# EUROPEAN PATENT APPLICATION

(11) **EP 4 421 221 A1**
(43) Date of publication of application: **28.08.2024**
(21) Application number: 22883613.6
(22) Date of filing: 19.10.2022
(51) Int. Cl.: C30B 29/36, H01L 21/205

(54) **SIC SUBSTRATE SIC COMPOSITE SUBSTRATE**

(30) Priority: 22.10.2021 WO PCT/JP2021/039155
(71) Applicant: NGK Insulators, Ltd., Nagoya city, Aichi 467-8530 (JP)
(72) Inventor: URATA, Yuki, Nagoya-City, Aichi 467-8530 (JP); MATSUSHIMA, Kiyoshi, Nagoya-City, Aichi 467-8530 (JP); YOSHIKAWA, Jun, Nagoya-City, Aichi 467-8530 (JP)
(74) Representative: Müller-Boré & Partner Patentanwälte PartG mbB
(86) International application number: PCT/JP2022/039004
(87) International publication number: WO 2023/068309

(57) **Abstract**

There is provided a SiC substrate in which TSD density of the surface is very low. This substrate is a SiC substrate including a biaxially oriented SiC layer, wherein when a surface of the biaxially oriented SiC layer is analyzed by photoluminescence (PL) to obtain a graph by plotting PL intensity I as the vertical axis versus distance (µm) in the [11-20] direction as the horizontal axis, (i) the graph has a shape such that a maximum point and a minimum point are repeated, wherein the maximum point is defined as a point that gives PL intensity I higher than PL intensity I of any other point among six points in total consisting of points that are the first nearest, points that are the second nearest, and points that are the third nearest on the right and left of the maximum point, and the minimum point is defined as a point that gives PL intensity I lower than PL intensity I of any other point among six points in total consisting of points that are the first nearest, points that are the second nearest, and points that are the third nearest on the right and left of the minimum point, (ii) when a maximum value of PL intensity I at a given maximum point P_{M} is assumed to be M, and a minimum value of PL intensity I at a minimum point Pₘ whose distance in the [11-20] direction is longer than that of the maximum point P_{M}, and the minimum point Pₘ being present at a position nearest to the maximum point P_{M}, is assumed to be m, a ratio of M/m is 1.05 or more, and (iii) distance L in the [11-20] direction between the maximum point P_{M} and the minimum point Pₘ is 15 to 150 µm.

## Description

### TECHNICAL FIELD

The present invention relates to a SiC substrate and a SiC composite substrate.

### BACKGROUND ART

SiC (silicon carbide) has attracted attention as a wide bandgap material capable of controlling large voltage and large electric power with low loss. In recent years in particular, power semiconductor devices using SiC materials (SiC power devices) are superior to those using Si semiconductors in terms of downsizing, low power consumption, and high efficiency, and therefore are expected to be utilized in various applications. For example, by adopting the SiC power devices, a converter, an inverter, an in-vehicle charger, and the like for an electric vehicle (EV) or a plug-in hybrid vehicle (PHEV) can be downsized, making it possible to improve efficiency.

To utilize a SiC power device for high withstand voltage applications, defects in a SiC wafer need to be decreased to the utmost limit in order to cope with a large current, thereby lowering of device characteristics needs to be suppressed. In this respect, a solution growth method is known as a method for decreasing defects in a wafer, particularly threading screw dislocations (TSDs) which are considered to be a cause for deterioration in withstand voltage. For example, Patent Literature 1 (JP2014-043369A) discloses a method for manufacturing a SiC single crystal comprising the steps of forming a macrostep composed of a SiC single crystal and having a height of higher than 70 nm on a (0001) plane of a SiC seed crystal to provide a second seed crystal, and growing a SiC single crystal on a (0001) plane of the second seed crystal in a reaction atmosphere comprising Si and C to cause the macrostep to progress on threading screw dislocations in the second seed crystal. It is stated that according to this manufacturing method, a SiC single crystal in which the threading screw dislocations are small in number is obtained. However, when a SiC substrate is produced by a solution growth method, there are problems that, for example, macrodefects, such as solvent inclusion due to surface roughness and different polymorphic crystal forms, are likely to occur.

On the other hand, as a method other than the solution growth method, a method of forming a SiC epitaxial layer by a chemical vapor deposition method is known. For example, Non-Patent Literature 1 (Lixia Zhao et al. "Surface defects in 4H-SiC homoepitaxial layers" Nanotechnology and Precision Engineering 3 (2020) 229-234) discloses that a SiC epitaxial layer is obtained by a chemical vapor deposition method and the forms and structures of the surface defects have been investigated, and states that the TSD density of a SiC substrate is generally 300 to 500 cm⁻².

### CITATION LIST

### PATENT LITERATURE

Patent Literature 1: JP2014-043369A

### NON-PATENT LITERATURE

Non-Patent Literature 1: Lixia Zhao et al. "Surface defects in 4H-SiC homoepitaxial layers" Nanotechnology and Precision Engineering 3 (2020) 229-234
Non-Patent Literature 2: Toru Ujihara et al. "Conversion Mechanism of Threading Screw Dislocation during SiC Solution Growth" Materials Science Forum Vols. 717-720, pp. 351-354 (2012)

### SUMMARY OF INVENTION

However, according to the disclosure of Non-Patent Literature 1, most of the TSDs on the substrate are propagated to the epitaxial layer, and therefore it is difficult to allow the TSD density of the substrate surface to fall well below 300 cm⁻². Therefore, further decrease in the TSD density at the SiC substrate surface is desired.

The present inventors have now discovered that a biaxially oriented SiC layer that satisfies predetermined conditions when analyzed by photoluminescence (PL) provides a SiC substrate in which the TSD density of the surface is very low.

Therefore, it is an object of the present invention to provide a SiC substrate in which the TSD density of the surface is very low.

The present invention provides the following aspects:
[Aspect 1]
   A SiC substrate comprising a biaxially oriented SiC layer, wherein when a surface of the biaxially oriented SiC layer is analyzed by photoluminescence (PL) to obtain a graph by plotting PL intensity I as the vertical axis versus distance (µm) in the [11-20] direction as the horizontal axis,
   (i) the graph has a shape such that a maximum point and a minimum point are repeated, wherein the maximum point is defined as a point that gives PL intensity I higher than PL intensity I of any other point among six points in total consisting of points that are the first nearest, points that are the second nearest, and points that are the third nearest on the right and left of the maximum point, and the minimum point is defined as a point that gives PL intensity I lower than PL intensity I of any other point among six points in total consisting of points that are the first nearest, points that are the second nearest, and points that are the third nearest on the right and left of the minimum point,
   (ii) when a maximum value of PL intensity I at a given maximum point P_{M} is assumed to be M, and a minimum value of PL intensity I at a minimum point Pₘ whose distance in the horizontal axis direction is longer than that of the maximum point P_{M}, and the minimum point Pₘ being present at a position nearest to the maximum point P_{M}, is assumed to be m, a ratio of M/m is 1.05 or more, and
   (iii) distance L in the [11-20] direction between the maximum point P_{M} and the minimum point Pₘ is 15 to 150 µm.
[Aspect 2]
   The SiC substrate according to aspect 1, wherein the distance L is 50 to 150 µm.
[Aspect 3]
   A SiC substrate comprising a biaxially oriented SiC layer, wherein when in an image obtained by analyzing a surface of the biaxially oriented SiC layer by photoluminescence (PL), the [11-20] direction of the image is processed with a Prewitt filter to obtain a graph by plotting PL intensity I_{F} as the vertical axis versus distance (µm) in the [11-20] direction as the horizontal axis,
   (i) the graph has a shape such that a plurality of maximum points is repeated, wherein the maximum point is defined as a point that gives PL intensity I_{F} higher than PL intensity I_{F} of any other point among six points in total consisting of points that are the first nearest, points that are the second nearest, and points that are the third nearest on the right and left of the maximum point, and
   (ii) distance L_{F} in the [11-20] direction between a given maximum point P_{M}, and a maximum point P_{M2} whose distance in the horizontal axis direction is longer than that of the maximum point P_{M1}, the maximum point P_{M2} being present at a position nearest to the maximum point P_{M1}, is 30 to 300 µm.
[Aspect 4]
   The SiC substrate according to any one of aspects 1 to 3, wherein the biaxially oriented SiC layer is oriented in the c-axis direction and the a-axis direction, and when a graph is obtained for the biaxially oriented SiC layer by plotting threading screw dislocation (TSD) density (cm⁻²) as the vertical axis versus depth (µm) from a (0001) plane that is a substrate surface to an arbitrary (000-1) plane as the horizontal axis, the graph comprises a TSD sloped region where the TSD density is decreased at a constant slope a as the depth decreases and the absolute value of the slope a is 5.0 cm⁻²/ µm or more.
[Aspect 5]
   The SiC substrate according to any one of aspects 1 to 4, wherein the biaxially oriented SiC layer comprises boron in a concentration of 1.0 × 10¹⁶ to 1.0 × 10¹⁷ atoms/cm³.
[Aspect 6]
   The SiC substrate according to aspect 4, wherein the absolute value of the slope a is 5.0 to 25 cm⁻²/ µm.
[Aspect 7]
   A SiC composite substrate comprising:
   a SiC single crystal substrate; and
   the SiC substrate according to any one of aspects 1 to 6 on the SiC single crystal substrate.

### BRIEF DESCRIPTION OF DRAWINGS

Figure 1 is a longitudinal cross-sectional view of a SiC composite substrate 10.
Figure 2 is a diagram showing a process of manufacturing the SiC composite substrate 10.
Figure 3 is a schematic cross-sectional view showing a configuration of an aerosol deposition (AD) apparatus.
Figure 4 is a photoluminescence (PL) image in a (0001) plane of a biaxially oriented SiC layer obtained in Example 1.
Figure 5 is a graph obtained by plotting PL intensity I as the vertical axis versus distance (µm) in the [11-20] direction as the horizontal axis, the graph created based on the PL image in the (0001) plane of the biaxially oriented SiC layer obtained in Example 1.
Figure 6 is an image obtained by processing, with a Prewitt filter, the PL image in the (0001) plane of the biaxially oriented SiC layer obtained in Example 1.
Figure 7 is a graph obtained by plotting PL intensity I_{F} as the vertical axis versus distance (µm) in the [11-20] direction as the horizontal axis, the graph created based on the image obtained by processing, with a Prewitt filter, the PL image in the (0001) plane of the biaxially oriented SiC layer obtained in Example 1.
Figure 8 is a graph obtained by plotting threading screw dislocation (TSD) density (cm⁻²) as the vertical axis versus depth (µm) from the (0001) plane to an arbitrary (000-1) plane of the biaxially oriented SiC layer obtained in Example 1 as the horizontal axis.
Figure 9 is an optical microscope image showing a step-terrace structure of a substrate surface of a SiC substrate obtained by a solution growth method, the image inserted in Non-Patent Literature 2.

### DESCRIPTION OF EMBODIMENTS

### SiC Substrate

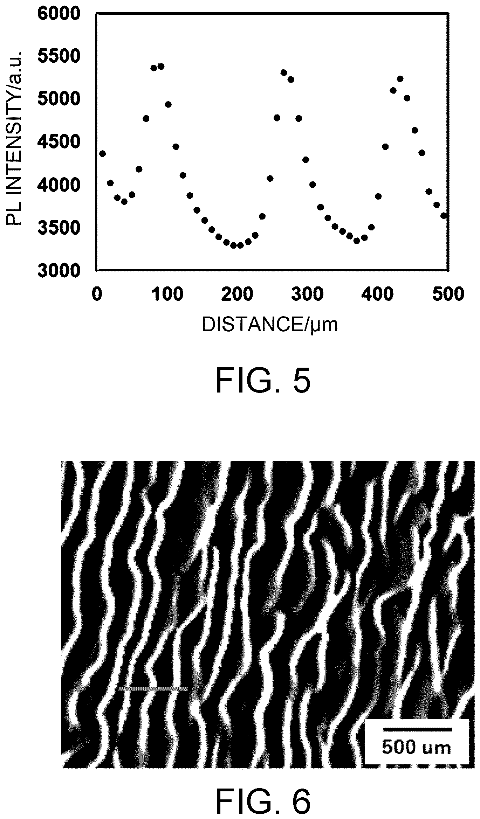

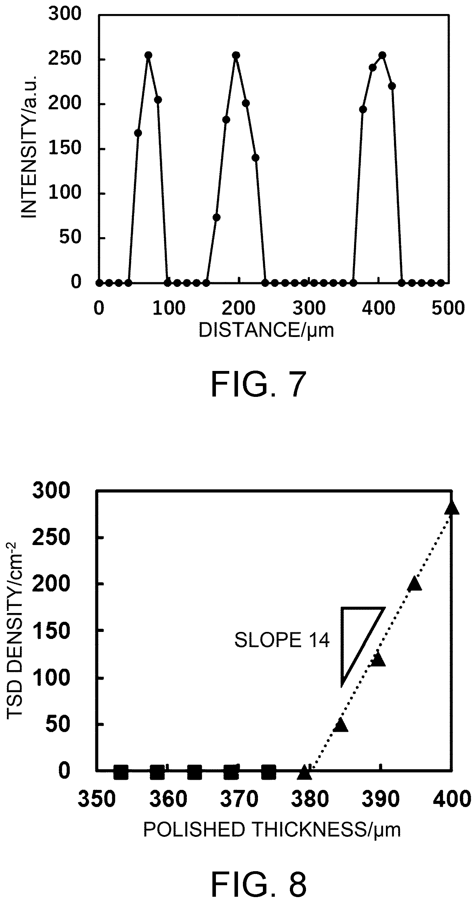

A SiC substrate according to the present invention is a SiC substrate comprising a biaxially oriented SiC layer. When a surface of this biaxially oriented SiC layer is analyzed by photoluminescence (PL) to obtain a graph by plotting PL intensity I as the vertical axis versus distance (µm) in the [11-20] direction as the horizontal axis, (i) the graph has a specific shape such that a maximum point and a minimum point are repeated, as shown in Figure 5 for example, which will be described later. Here, the maximum point is defined as a point that gives PL intensity I higher than PL intensity I of any other point among six points in total consisting of points that are the first nearest, points that are the second nearest, and points that are the third nearest on the right and left of the maximum point, and the minimum point is defined as a point that gives PL intensity I lower than PL intensity I of any other point among six points in total consisting of points that are the first nearest, points that are the second nearest, and points that are the third nearest on the right and left of the minimum point. This graph satisfies the following conditions: (ii) When a maximum value of PL intensity I at a given maximum point P_{M} is assumed to be M, and a minimum value of PL intensity I at a minimum point Pₘ whose distance in the horizontal axis direction is longer than that of the maximum point P_{M}, and the minimum point Pₘ being present at a position nearest to the maximum point P_{M}, is assumed to be m, a ratio of M/m is 1.05 or more; and
(iii) Distance L in the [11-20] direction between the maximum point P_{M} and the minimum point Pₘ is 15 to 150 µm. Alternatively, when in an image obtained by analyzing a surface of the biaxially oriented SiC layer by PL, the [11-20] direction of the image is processed with a Prewitt filter to obtain a graph by plotting PL intensity I_{F} as the vertical axis versus distance (µm) in the [11-20] direction as the horizontal axis, (iv) the graph has a shape such that a plurality of maximum points is repeated, as shown in Figure 7 for example, which will be described later. Here, the maximum point is defined as a point that gives PL intensity I_{F} higher than PL intensity I_{F} of any other point among six points in total consisting of points that are the first nearest, points that are the second nearest, and points that are the third nearest on the right and left of the maximum point. This graph satisfies the following condition:
(v) Distance L_{F} in the [11-20] direction between a given maximum point P_{M}, and a maximum point P_{M2} whose distance in the horizontal axis direction is longer than that of the maximum point P_{M1}, the maximum point P_{M2} being present at a position nearest to the maximum point P_{M1}, is 30 to 300 µm.

When a SiC substrate comprising a biaxially oriented SiC layer is analyzed by PL, and the biaxially oriented SiC layer satisfies predetermined conditions, as just described above, the biaxially oriented SiC layer can provide a SiC substrate in which the TSD density of the surface is very low. In addition, such a SiC substrate can be produced without using a solution growth method, and therefore a macrodefect on the substrate surface is unlikely to occur.

As described above, with regard to conventional SiC substrates, when a SiC substrate is produced by a solution growth method for example, there are problems that, for example, macrodefects, such as solvent inclusion due to surface roughness and different polymorphic crystal forms, are likely to occur. In addition, even when a SiC epitaxial layer is formed by a chemical vapor deposition method, most of the TSDs on the substrate are propagated to the epitaxial layer, and therefore it has been considered to be difficult to allow the TSD density of the substrate surface to fall well below 300 cm⁻². In this respect, according to the SiC substrate of the present invention, the problems can be conveniently solved.

The biaxially oriented SiC layer that forms the SiC substrate of the present invention is such that in the case where a surface of the biaxially oriented SiC layer is analyzed by PL to obtain a graph by plotting PL intensity I as the vertical axis versus distance (µm) in the [11-20] direction as the horizontal axis, when a maximum value of PL intensity I at a given maximum point P_{M} is assumed to be M, and a minimum value of PL intensity I at a minimum point Pₘ whose distance in the [11-20] direction is longer than that of the maximum point P_{M}, and the minimum point Pₘ being present at a position nearest to the maximum point P_{M}, is assumed to be m, a ratio of M/m is 1.05 or more (hereinafter, referred to as condition (ii)). Although the upper limit is not particularly limited, this ratio of M/m is preferably 1.05 to 1.80.

Further, in the graph obtained by analyzing the surface of the biaxially oriented SiC layer by PL, the distance L in the [11-20] direction between the maximum point P_{M} and the minimum point Pₘ is 15 to 150 µm (hereinafter, referred to as condition (iii)), preferably 50 to 150 µm, more preferably 50 to 120 µm, and further preferably 50 to 100 µm.

The graph typically has a regular pattern in which a waveform including a maximum point and a minimum point are repeated at a constant cycle, as shown in Figure 5 for example, which will be described later. Therefore, when at least one of a plurality of maximum points present on a predetermined measured line segment (for example, a 500 µm line segment) parallel to the [11-20] direction (and a minimum point corresponding to the at least one of the maximum points) satisfies the conditions (ii) and (iii), the SiC substrate is defined as one satisfying the conditions (ii) and (iii). However, at least two of the maximum points (and minimum points corresponding to the at least two of the maximum points) more preferably and further preferably at least three of the maximum points satisfy the conditions (ii) and (iii).

Alternatively, the biaxially oriented SiC layer that forms the SiC substrate of the present invention is such that when in an image obtained by analyzing a surface of the biaxially oriented SiC layer by PL, the [11-20] direction of the image is processed with a Prewitt filter to obtain a graph by plotting PL intensity I_{F} as the vertical axis versus distance (µm) in the [11-20] direction as the horizontal axis, distance L_{F} in the [11-20] direction between a given maximum point P_{M}, and a maximum point P_{M2} whose distance in the [11-20] direction is longer than that of the maximum point P_{M1}, the maximum point P_{M2} being present at a position nearest to the maximum point P_{M1}, is 30 to 300 µm (hereinafter, referred to as condition (v)), preferably 100 to 300 µm, more preferably 100 to 240 µm, and further preferably 100 to 200 µm.

In the graph obtained by Prewitt filter processing, a plurality of maximum points is repeated as shown in Figure 7 for example, which will be described later. Therefore, when at least one combination (P_{M1} and P_{M2}) of maximum points each satisfying the condition (v) is present among a plurality of maximum points present on a predetermined measured line segment (for example, a 500 µm line segment) parallel to the [11-20] direction, the SiC substrate is defined as one satisfying the condition (v). However, at least two such combinations are more preferably present, and three such combinations are further preferably present.

The biaxially oriented SiC layer is preferably oriented in the c-axis direction and the a-axis direction. In addition, the SiC substrate is preferably composed of the biaxially oriented SiC layer. The biaxially oriented SiC layer may be a SiC single crystal, or a mosaic crystal as long as the biaxially oriented SiC layer is oriented in the biaxial directions of the c-axis direction and the a-axis direction. The mosaic crystal refers to an aggregate of crystals not having clear grain boundaries but being such that the orientation directions of the crystals are slightly different from one or both of the c-axis and the a-axis. The method for evaluating the orientation is not particularly limited, but known analysis methods such as an EBSD (Electron Back Scatter Diffraction Patterns) method and an X-ray pole figure can be used. For example, when the EBSD method is used, inverse pole figure mapping of a surface (plate surface) of the biaxially oriented SiC layer or a section orthogonal to the plate surface is measured. When the following four conditions are satisfied in the resultant inverse pole figure mapping, the SiC layer can be defined as being biaxially oriented in an approximate normal direction and an approximate plate surface direction: (A) the SiC layer is oriented in a particular direction (the first axis) in an approximate normal direction of the plate surface; (B) the SiC layer is oriented in a particular direction (the second axis) in an approximate in-plate-surface direction, the direction orthogonal to the first axis; (C) tilt angles from the first axis are distributed within ±10°; and (D) tilt angles from the second axis are distributed within ±10°. In other words, when the four conditions are satisfied, the SiC layer is determined to be biaxially oriented along the c-axis and the a-axis. For example, when the approximate normal direction of the plate surface is oriented along the c-axis, the approximate in-plate-surface direction only needs to be oriented in a particular direction (for example, the a-axis) orthogonal to the c-axis. The biaxially oriented SiC layer only needs to be biaxially oriented in the approximate normal direction and the approximate in-plate-surface direction, but the approximate normal direction is preferably oriented along the c-axis direction. As a tilt angle distribution in the approximate normal direction and/or the approximate in-plate-surface direction is smaller, the mosaicity of the biaxially oriented SiC layer is smaller, and as the tilt angle distribution is closer to zero, the biaxially oriented SiC layer is closer to a single crystal. Therefore, in view of the crystallinity of the biaxially oriented SiC layer, the tilt angle distribution is preferably smaller in both the approximate normal direction and the approximate plate surface direction, more preferably, for example, ±5° or less, and further preferably ±3° or less.

As for the biaxially oriented SiC layer oriented in the c-axis direction and the a-axis direction, when a graph is obtained by plotting the TSD density (cm⁻²) as the vertical axis versus depth (µm) from a (0001) plane that is a substrate surface to an arbitrary (000-1) plane as the horizontal axis, the graph preferably comprises a TSD sloped region in at least a part of thereof, as shown in Figure 8 for example, which will be described later. This TSD sloped region effectively contributes to achievement of the SiC substrate in which the TSD density of the surface is very low. This TSD sloped region is a region where the TSD density is decreased at a constant slope a as the depth decreases. The absolute value of the slope a is 5.0 cm⁻²/ µm or more, preferably 5.0 to 25 cm⁻²/ µm, more preferably 10 to 25 cm⁻²/ µm, and further preferably 15 to 25 cm⁻²/ µm. This slope a can be calculated by, for example, determining an approximation straight line by the least-squares method in the TSD sloped region in the graph. "Depth from a (0001) plane that is a substrate surface to an arbitrary (000-1) plane" means depth from the (0001) plane that is the top surface of the biaxially oriented SiC layer toward the bottom surface direction of the biaxially oriented SiC layer on the SiC single crystal substrate side in the biaxially oriented SiC layer on the SiC single crystal substrate.

The biaxially oriented SiC layer preferably comprises boron in a concentration of 1.0 × 10¹⁶ to 1.0 × 10¹⁷ atoms/cm³, and more preferably 1.0 × 10¹⁶ to 9.5 × 10¹⁶ atoms/cm³. By controlling the boron content in this manner, the distribution of PL intensity can be preferably controlled in the above-described graph obtained by PL, and the SiC substrate in which the TSD density of the substrate surface is decreased can be effectively obtained.

### SiC Composite Substrate

The SiC substrate of the present invention may be a self-supporting substrate consisting of a SiC substrate or may be in the form of a SiC composite substrate. The SiC composite substrate can be one comprising: a SiC single crystal substrate; and the above-described SiC substrate on the SiC single crystal substrate.

The SiC single crystal substrate is typically a layer composed of a SiC single crystal and has a crystal growth surface. The polytype, off angle, and polarity of the SiC single crystal are not particularly limited, but the polytype is preferably 4H or 6H, the off angle is preferably 0.1 to 12° from the [0001] axis of single crystal SiC, and the polarity is preferably the Si surface. More preferably, the polytype is 4H, the off angle is 1 to 5° from the [0001] axis of single crystal SiC, and the polarity is the Si surface.

As described above, the SiC substrate of the present invention may be in the form of a self-supporting substrate consisting of a biaxially oriented SiC layer or may be in the form of a SiC composite substrate with a SiC single crystal substrate. Therefore, the biaxially oriented SiC layer may be finally separated from the SiC single crystal substrate as necessary. The separation of the SiC single crystal substrate may be performed by a known method and is not particularly limited. Examples of the known method include a method of separating the biaxially oriented SiC layer with a wire saw, a method of separating the biaxially oriented SiC layer by electro discharge machining, and a method of separating the biaxially oriented SiC layer utilizing laser. In an embodiment in which the biaxially oriented SiC layer is epitaxially grown on a SiC single crystal substrate, the biaxially oriented SiC layer may be installed on another support substrate after the SiC single crystal substrate is separated. The material of the another support substrate is not particularly limited and suitable one may be selected in view of physical properties of the material. In view of thermal conductivity for example, examples of the material include metal substrates such as a Cu substrate and ceramic substrates such as a SiC substrate and an AIN substrate.

### Method for Manufacturing SiC Composite Substrate

The SiC composite substrate comprising the SiC substrate of the present invention can be preferably manufactured by (a) forming a predetermined orientation precursor layer on a SiC single crystal substrate, (b) subjecting the orientation precursor layer to heat treatment on the SiC single crystal substrate to convert at least a portion of the orientation precursor layer near the SiC single crystal substrate into a SiC substrate (biaxially oriented SiC layer), and, optionally, (c) performing processing such as grinding or polishing to expose the surface of the biaxially oriented SiC layer. However, the method for manufacturing the SiC composite substrate is not limited as long as it is possible to obtain a SiC substrate such that when a SiC substrate comprising a biaxially oriented SiC layer is analyzed by PL, the particular analysis results as described above are obtained. For example, as the manufacturing method, vapor phase methods such as CVD and a sublimation method may be adopted, liquid phase methods such as a solution method may be adopted, or solid phase methods utilizing grain growth may be adopted. The distribution of PL intensity in the graph obtained by PL can be controlled by, for example, controlling heat treatment conditions in (b); or controlling the amount of boron or the boron compound (for example, boron carbide or the like) to be added in (a) forming an orientation precursor layer. According to such manufacturing methods, it is possible to produce a SiC substrate such that when a SiC substrate comprising a biaxially oriented SiC layer is analyzed by PL, the particular analysis results as described above are obtained, and it is possible to significantly decrease the TSD density on the surface of the SiC substrate or the SiC composite substrate using the SiC substrate.

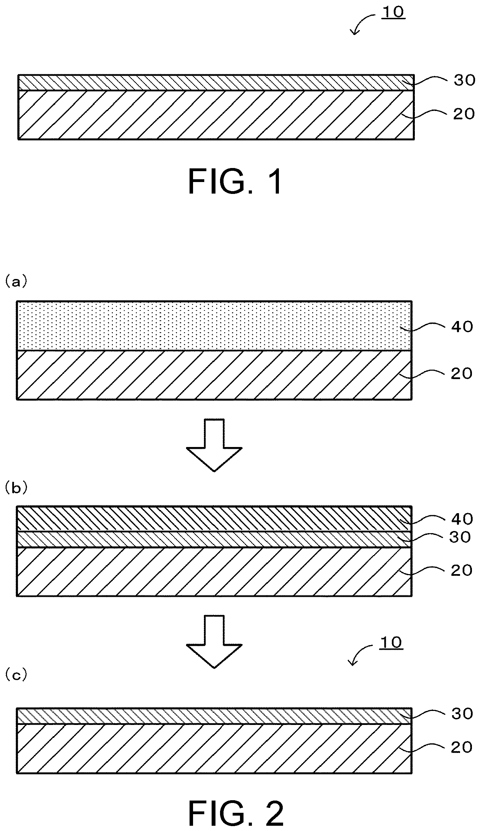

Hereinafter, a preferred method for manufacturing the SiC composite substrate will be described. Figure 1 is a longitudinal cross-sectional view of a SiC composite substrate 10 (a cross-sectional view obtained by cutting the SiC composite substrate 10 vertically along a plane including the central axis of the SiC composite substrate 10). Figure 2 is a diagram showing a process of manufacturing the SiC composite substrate 10.

As shown in Figure 1, the SiC composite substrate 10 of the present embodiment comprises: a SiC single crystal substrate 20; and a SiC substrate 30 (corresponding to the SiC substrate of the present invention) on the SiC single crystal substrate.

### (a) Process of Forming Orientation Precursor Layer

As shown in Figure 2(a), an orientation precursor layer 40 is made into the SiC substrate (biaxially oriented SiC layer) 30 by heat treatment, which will be described later. In the process of forming the orientation precursor layer 40, the orientation precursor layer 40 is formed on a crystal growth surface of the SiC single crystal substrate 20.

As the method for forming the orientation precursor layer 40, a known method can be adopted. Examples of the method for forming the orientation precursor layer 40 include solid phase film deposition methods such as an AD (Aerosol Deposition) method and a HPPD (Hypersonic Plasma Particle Deposition) method, vapor phase film deposition methods such as a sputtering method, a vapor deposition method, a sublimation method, and various CVD (Chemical Vapor Deposition) methods, and liquid phase film deposition methods such as a solution growth method, and a method of directly forming the orientation precursor layer 40 on the SiC single crystal substrate 20 can be used. As the CVD method, for example, a thermal CVD method, a plasma CVD method, a mist CVD method, and a MO (Metal Organic) CVD method can be used. Further, it is also possible to use a method in which a polycrystalline substance previously produced by a sublimation method, any of various CVD methods, sintering, or the like is used as the orientation precursor layer 40, and the polycrystalline substance is placed on the SiC single crystal substrate 20. Alternatively, the method for forming the orientation precursor layer 40 may also be a method in which a green body of the orientation precursor layer 40 is preliminarily produced, and this green body is placed on the SiC single crystal substrate 20. Such an orientation precursor layer 40 may be tape green body produced by tape casting or a green compact produced by pressure forming such as uniaxial pressing.

In forming these orientation precursor layers 40, a boron compound is preferably contained in the raw materials for the orientation precursor layers 40. Examples of the boron compound include, but not particularly limited to, boron carbide. As described above, the concentration of boron in the biaxially oriented SiC layer to be finally obtained can be controlled by, for example, controlling the amount of the boron compound to be added.

When any of various CVD methods, a sublimation method, a solution growth method, or the like is used in the method of directly forming the orientation precursor layer 40 on the SiC single crystal substrate 20, epitaxial growth may occur on the SiC single crystal substrate 20 without a heat treatment process, which will be described later, so that the SiC substrate 30 may be deposited. However, the orientation precursor layer 40 is preferably not oriented, specifically is preferably an amorphous or non-oriented polycrystal, at the time of formation, and is preferably oriented using a SiC single crystal as a seed in the heat treatment process in a later stage. Thus, crystal defects that reach the surface of the SiC substrate 30 can be effectively reduced. The reason for this is not certain, but it is considered that the solid phase orientation precursor layer once deposited causes rearrangement of the crystal structure using a SiC single crystal as a seed, and this may also have an effect in disappearance of crystal defects. Therefore, when any of various CVD methods, a sublimation method, a solution growth method, or the like is used, it is preferred to select conditions that do not cause epitaxial growth to occur in the process of forming the orientation precursor layer 40. However, it is difficult to decrease the TSD density sufficiently by only selecting such conditions, and therefore it is preferred to control the heat treatment conditions such as firing temperature; the amount of boron to be added; and the like.

However, the method for forming the orientation precursor layer 40 is preferably a method of directly forming the orientation precursor layer 40 on the SiC single crystal substrate 20 by an AD method or any of various CVD methods, or a method of placing a polycrystalline substance on the SiC single crystal substrate 20, wherein the polycrystalline substance is separately produced by a sublimation method, any of various CVD methods, sintering, or the like. The use of these methods makes it possible to form the orientation precursor layer 40 in a relatively short time. The AD method is particularly preferred because a high-vacuum process is unnecessary, and the film deposition rate is relatively high. In the method using a previously produced polycrystalline substance as the orientation precursor layer 40, ingenuity such as making the surface of the polycrystalline substance sufficiently smooth in advance is necessary in order to enhance the adhesion between the polycrystalline substance and the SiC single crystal substrate 20. Therefore, the method of directly forming the orientation precursor layer 40 is preferred in view of cost. The method of placing a previously produced green body on the SiC single crystal substrate 20 is also preferred as a simple method, but the orientation precursor layer 40 is composed of a powder, and therefore a sintering process is necessary in the heat treatment process, which will be described later. Known conditions can be used in any of the methods, but hereinafter, description will be made on the method of directly forming the orientation precursor layer 40 on the SiC single crystal substrate 20 by an AD method or a thermal CVD method and the method of placing a previously produced green body on the SiC single crystal substrate 20.

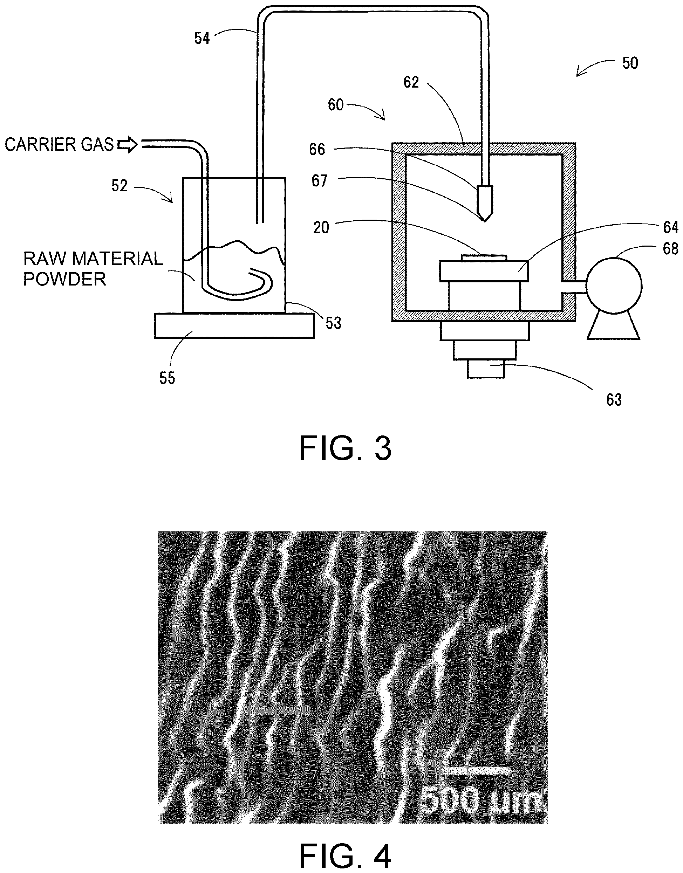

The AD method is a technique such that fine particles or fine particle raw materials are mixed with a gas to form aerosol, and this aerosol is jetted at a high speed from a nozzle to allow the aerosol to collide with a substrate to form a coat and has a characteristic that the coat can be formed at normal temperature. Figure 3 shows an example of a film deposition apparatus (AD apparatus) that is used in such an AD method. An AD apparatus 50 shown in Figure 3 is configured as an apparatus that is used in an AD method in which a raw material powder is jetted onto a substrate in an atmosphere where the air pressure is lower than the atmospheric pressure. This AD apparatus 50 comprises: an aerosol generation unit 52 that generates aerosol of a raw material powder containing raw material components; and a film deposition unit 60 that jets the raw material powder onto the SiC single crystal substrate 20 to form a film containing the raw material components. The aerosol generation unit 52 comprises: an aerosol generation chamber 53 that receives supply of a carrier gas from a gas cylinder that stores the raw material powder, the gas cylinder not shown, to generate aerosol; a raw material supply pipe 54 that supplies generated aerosol to the film deposition unit 60; and a vibration exciter 55 that gives vibration of a frequency of 10 to 100 Hz to the aerosol generation chamber 53 and the aerosol therein. The film deposition unit 60 comprises: a film deposition chamber 62 that jets the aerosol onto the SiC single crystal substrate 20; a substrate holder 64 that is fixedly set up inside the film deposition chamber 62 to fix the SiC single crystal substrate 20; and an X-Y stage 63 that moves the substrate holder 64 in the X-axis and Y-axis directions. Further, the film deposition unit 60 comprises: a jet nozzle 66 that has a slit 67 formed at the tip and jets the aerosol onto the SiC single crystal substrate 20; and a vacuum pump 68 that reduces the pressure in the film deposition chamber 62. The jet nozzle 66 is attached to the tip of the raw material supply pipe 54.

The AD method is known to generate pores in a film or make a film into a green compact depending on the film deposition conditions. For example, the AD method is susceptible to the collision speed of the raw material powder onto the substrate, the particle size of the raw material powder, the aggregation state of the raw material powder in the aerosol, the jetting amount per unit time, and the like. The collision speed of the raw material powder onto the substrate is influenced by the differential pressure between the inside of the film deposition chamber 62 and the inside of the jet nozzle 66, the opening area of the jet nozzle, and the like. Therefore, to obtain a dense orientation precursor layer, these factors need to be controlled properly.

In the thermal CVD method, known film deposition apparatuses such as commercially available film deposition apparatuses can be utilized as a film deposition apparatus. The raw material gas is not particularly limited, and a silicon tetrachloride (SiCl₄) gas and a silane (SiH₄) gas as a supply source of Si, and a methane (CH₄) gas, a propane (C₃H₈) gas, and the like as a supply source of C can be used. The film deposition temperature is preferably 1000 to 2200°C, more preferably 1100 to 2000°C, and further preferably 1200 to 1900°C.

When the orientation precursor layer 40 is deposited on the SiC single crystal substrate 20 using the thermal CVD method, it is known that epitaxial growth may occur on the SiC single crystal substrate 20 to form the SiC substrate 30. However, the orientation precursor layer 40 is preferably not oriented, specifically is preferably an amorphous or non-oriented polycrystal, at the time of production, and it is preferred to allow rearrangement of the crystals to occur using a SiC single crystal as a seed crystal during the heat treatment process. The film deposition temperature, the flow rates of gases such as a Si source and a C source and the ratio thereof, the film deposition pressure, and the like are known to give influences in forming an amorphous or polycrystal layer on a SiC single crystal using the thermal CVD method. The influence of the film deposition temperature is large, and in view of forming an amorphous or polycrystal layer, the film deposition temperature is preferably lower, preferably lower than 1700°C, more preferably 1500°C or lower, and further preferably 1400°C or lower. However, when the film deposition temperature is too low, the film deposition rate itself is also lowered, and therefore the film deposition temperature is preferably higher in view of the film deposition rate.

When a previously produced green body is used as the orientation precursor layer 40, the green body can be produced by forming a raw material powder for the orientation precursor. For example, when press forming is used, the orientation precursor layer 40 is a press-formed green body. The press-formed green body can be produced by subjecting the raw material powder for the orientation precursor to press forming based on a known method and may be produced by, for example, putting the raw material powder into a metal mold and pressing the raw material powder at a pressure of preferably 100 to 400 kgf/cm², and more preferably 150 to 300 kgf/cm². The forming method is not particularly limited, and tape casting, extrusion forming, slip casting, and a doctor blade method, and optional combinations thereof can be used in addition to press forming. For example, when tape casting is used, additives such as a binder, a plasticizer, a dispersant, and a dispersion medium are appropriately added to the raw material powder to make a slurry, and this slurry is preferably allowed to pass through a slit-like thin ejection port to be ejected and formed into a sheet. The thickness of the green body formed into a sheet is not limited but is preferably 5 to 500 µm in view of handling. When a thick orientation precursor layer is necessary, a plurality of the sheet green bodies may be stacked into a desired thickness for use. A portion of these green bodies near the SiC single crystal substrate 20 is made into the SiC substrate 30 by the subsequent heat treatment on the SiC single crystal substrate 20. In such a method, the green bodies need to be sintered in the heat treatment process, which will be described later. The SiC substrate 30 is preferably formed after the green bodies are subjected to the process in which the green bodies are sintered and integrated as a polycrystalline substance with the SiC single crystal substrate 20. When the green bodies do not undergo a sintered state, epitaxial growth using a SiC single crystal as a seed may occur insufficiently. Therefore, the green body may contain an additive such as a sintering aid in addition to the SiC raw material.

### (b) Heat Treatment Process

As shown in Figure 2(b), in the heat treatment process, a laminate in which the orientation precursor layers 40 are laminated or placed on the SiC single crystal substrate 20 are subjected to heat treatment to generate the SiC substrate 30. The heat treatment method is not particularly limited as long as epitaxial growth using the SiC single crystal substrate 20 as a seed occurs, and can be performed in a known heat treatment furnace such as a tube furnace or a hot plate. Not only heat treatment under normal pressure (pressless heat treatment) but also heat treatment under pressure such as hot pressing and HIP and a combination of the heat treatment under normal pressure and the heat treatment under pressure can be used. The atmosphere during the heat treatment can be selected from vacuum, nitrogen, and inert gas atmospheres. The heat treatment temperature is preferably 1700 to 2700°C. By increasing the temperature, the orientation precursor layer 40 is likely to grow using the SiC single crystal substrate 20 as a seed crystal while being oriented along the c-axis and the a-axis. Therefore, the heat treatment temperature is preferably 1700°C or higher, more preferably 1850°C or higher, further preferably 2000°C or higher, and particularly preferably 2200°C or higher. On the other hand, when the temperature is excessively high, there is a possibility that part of SiC is lost by sublimation or SiC is plastically deformed to cause a defect such as, for example, a warp. Therefore, the heat treatment temperature is preferably 2700°C or lower, and more preferably 2500°C or lower. However, the heat treatment conditions give an influence on the distribution of PL intensity in the graph obtained by PL of the surface of the biaxially oriented SiC layer, and therefore it is preferred to appropriately control the conditions (for example, the heat treatment temperature and holding time). From such viewpoints, the heat treatment temperature is preferably 2000 to 2700°C, more preferably 2200 to 2600°C, and further preferably 2400 to 2500°C. The holding time is preferably 2 to 30 hours, and more preferably 4 to 20 hours. The heat treatment temperature and the holding time have a relationship with the thickness of the SiC substrate 30 generated by epitaxial growth and can be appropriately adjusted.

However, a previously produced green body, when used as the orientation precursor layer 40, needs to be sintered during the heat treatment, and normal pressure firing at a high temperature, hot pressing, HIP, or a combination thereof is suitable. For example, when hot pressing is used, the surface pressure is preferably 50 kgf/cm² or higher, more preferably 100 kgf/cm² or higher, and further preferably 200 kgf/cm² or higher, and there is no upper limit in particular. In addition, the firing temperature is not particularly limited as long as sintering and epitaxial growth occur. However, the firing conditions give an influence on the distribution of PL intensity in the graph obtained by PL of the surface of the biaxially oriented SiC layer, and therefore it is preferred to appropriately control the conditions (for example, the firing temperature and holding time). From such viewpoints, the firing temperature is preferably 1700 to 2700°C. The holding time is preferably 2 to 18 hours. The atmosphere during the firing can be selected from vacuum, nitrogen, and inert gas atmospheres, or a mixed gas of nitrogen and an inert gas. The SiC powder which is a raw material may be any of an α-SiC powder and a β-SiC powder, but is preferably a β-SiC powder. The SiC powder is preferably composed of SiC particles having an average particle size of 0.01 to 100 µm. The average particle size refers to an average value obtained when the powder is observed with a scanning electron microscope to measure the maximum sizes in a constant direction for 100 primary particles.

In the heat treatment process, the crystals in the orientation precursor layer 40 grow while being oriented along the c-axis and the a-axis from the crystal growth surface of the SiC single crystal substrate 20, and therefore the orientation precursor layer 40 is gradually changed into the SiC substrate 30 from the crystal growth surface. The SiC composite substrate comprising the generated SiC substrate 30 is such that the TSD density of the substrate surface is decreased. The reason for this is not clear, but it is considered that this is because the distribution of PL intensity reflects a step-terrace structure that is generated during crystal growth, and the TSDs have been converted to lamination defects with the crystal growth.

### (c) Grinding and Polishing Process

As shown in Figure 2(c), in the grinding and polishing process, the orientation precursor layer 40 left on the SiC substrate 30 after the heat treatment process is ground away to expose the surface of the SiC substrate 30, the exposed surface is subjected to polishing using diamond abrasive grains and is optionally subjected to a CMP (Chemical Mechanical Polishing) finish. Thus, the SiC composite substrate 10 is obtained. The SiC single crystal substrate 20 of the SiC composite substrate 10, when desired to be removed, is subjected to, for example, surface grinding to a predetermined thickness with a grinder and subsequently may be subjected to polishing using diamond abrasive grains.

The present invention is not limited to the above-described embodiments, and it is needless to say that that the present invention can be conducted in various aspects as long as they belong to the technical scope of the present invention. For example, in the above-described embodiment, only one layer of the SiC substrate 30 is provided on the SiC single crystal substrate 20, but two or more layers may be provided. Specifically, by laminating the orientation precursor layer 40 on the SiC substrate 30 of the SiC composite substrate 10, and performing heat treatment and grinding in the mentioned order, the SiC substrate 30 as the second layer can be provided on the SiC substrate 30.

### EXAM PLES

The present invention will be more specifically described by the following examples. The present invention is not limited only by the following Examples.

### Example 1

### (1) Production of Orientation Precursor Layer

A raw material powder containing 90.8% by weight of a commercially available β-SiC fine powder (volume-based D50 particle size: 0.7 µm), 8.1% by weight of an yttrium oxide powder (volume-based D50 particle size: 0.1 µm), and 1.1% by weight of a silicon dioxide powder (volume-based D50 particle size: 0.7 µm) was mixed with a ball mill using SiC balls in ethanol for 24 hours, and the resultant mixture was dried to obtain a mixed powder. A commercially available SiC single crystal substrate (n-type 4H-SiC, diameter 100 mm (4 inches), Si surface, (0001) plane, off angle 4°, thickness 0.35 mm, without an orientation flat) was provided, and the mixed powder was jetted onto the SiC single crystal substrate with the AD apparatus 50 shown in Figure 3 to form an AD film (orientation precursor layer).

Conditions for depositing the AD film were as follows. Firstly, N₂ was used as a carrier gas, and the film was deposited using a nozzle made of a ceramic and being such that a slit of 5 mm in long side × 0.4 mm in short side was formed. The condition for scanning the nozzle was as follows. The scan speed was set to 0.5 mm/s, the following scans were repeated: moving the nozzle 105 mm in a vertical and advancing direction with respect to the long side of the slit; moving the nozzle 5 mm in the long side direction of the slit; moving the nozzle 105 mm in a vertical and returning direction with respect to the long side of the slit; and moving the nozzle 5 mm in the long side direction of the slit and the opposite direction to the initial position, at the time when the nozzle was moved 105 mm from the initial position in the long side direction of the slit, scans were conducted in directions opposite to the previous directions to return the nozzle to the initial position, and this cycle was defined as one cycle, and this cycle was repeated up to 4000 cycles. The AD film thus formed had a thickness of about 400 µm.

### (2) Heat Treatment of Orientation Precursor Layer

The SiC single crystal substrate on which the AD film, which is the orientation precursor layer was formed was taken out of the AD apparatus, and annealed in an argon atmosphere at 2400°C for 10 hours. In other words, the orientation precursor layer was subjected to heat treatment to form a heat-treated layer. Thus, a SiC composite substrate including a heat-treated layer formed on a SiC single crystal substrate was produced.

### (3) Grinding and Polishing

### (3-1) Surface Polishing

A (0001) plane (that is, heat-treated layer surface) of the SiC composite substrate including a heat-treated layer formed on the SiC single crystal substrate was subjected to polishing using diamond abrasive grains (whose grain sizes are 3.0 µm, 1.0 µm, 0.5 µm, and 0.1 µm respectively) in descending order of grain size into a targeted thickness and surface state.

### (3-2) Bottom Surface Polishing

After (3-1), a (000-1) plane of the SiC composite substrate including a heat-treated layer formed on the SiC single crystal substrate was subjected to surface grinding with a grinder (diamond wheel of #1000 to 6000) to a predetermined thickness. Subsequently, the (000-1) plane was subjected to polishing using diamond abrasive grains (whose grain sizes are 3.0 µm, 1.0 µm, 0.5 µm, and 0.1 µm respectively) in descending order of grain size. Thereby, the whole of the SiC single crystal substrate was ground to obtain a substrate (SiC substrate) consisting of the heat-treated layer.

### (4) Cutting of Sample

The SiC composite substrate or the SiC substrate obtained as a sample in (3-1) or (3-2), was cut with a diamond cutter to be processed into a chip shape of 5 mm × 6 mm.

### (5) Evaluation

### (5-1) Biaxial Orientation Property of Heat-Treated Layer

Inverse pole figure mapping was measured using the EBSD (Electron Back Scatter Diffraction Patterns) method for the surface (plate surface) and section orthogonal to the plate surface of the heat-treated layer produced in (3-1) and (3-2) under the following conditions to find the tilt angle distribution to be 0.01° or less for both the approximate normal direction and the approximate plate surface direction, and therefore the heat-treated layer was determined to be a biaxially oriented SiC layer oriented along the c-axis and the a-axis.

### <Conditions for EBSD Measurement>

- Acceleration voltage: 15 kv
- Spot intensity: 70
- Working distance: 22.5 mm
- Step size: 0.5 µm
- Tilt angle of sample: 70°
- Measurement program: Aztec (version 3.3)

### (5-2) Measurement of Photoluminescence (PL) of Biaxially Oriented SiC Layer

The sample obtained by processing the heat-treated layer (biaxially oriented SiC layer) produced in (1) to (4) into a chip shape was used as an evaluation sample to obtain a PL image of the evaluation sample surface. At this time, as shown in Figure 4, an arbitrary region of 3.0 mm × 2.2 mm in the obtained PL image was cut out. At an arbitrary position in this region, a 500 µm line segment (in Figure 4, a part shown by a lower-left line segment) parallel to the [11-20] direction was drawn. As shown in Figure 5, a graph was created by plotting PL intensity I as the vertical axis versus distance (µm) in the [11-20] direction as the horizontal axis in the line segment region. This graph had a shape such that a maximum point and a minimum point are repeated. The maximum point was confirmed to be a point that gives PL intensity I higher than PL intensity I of any other point among six points in total consisting of points that are the first nearest, points that are the second nearest, and points that are the third nearest on the right and left of the maximum point, and the minimum point was confirmed to be a point that gives PL intensity I lower than PL intensity I of any other point among six points in total consisting of points that are the first nearest, points that are the second nearest, and points that are the third nearest on the right and left of the minimum point. In addition, M/m was calculated from this Figure 5, wherein a maximum value of PL intensity I at a given maximum point P_{M} is assumed to be M, and a minimum value of PL intensity I at a minimum point Pₘ whose distance in the horizontal axis direction is longer than that of the maximum point P_{M}, and the minimum point Pₘ being present at a position nearest to the maximum point P_{M}, is assumed to be m. Further, distance L in the [11-20] direction between the maximum point P_{M} and the minimum point Pₘ was measured. The results were as shown in Table 1. The measurement conditions at this time were as shown below. It was found from Figure 4 that in the step-terrace structure on the heat-treated layer surface, the step width was wide, as wide as about 100 to about 200 µm.

### <Conditions for PL Measurement>

- Excitation wavelength: 313 nm
- Detection wavelength: 750 nm or longer
- Measurement temperature: room temperature
- Detector: CCD camera (Roper Scientific)

Further, in the image obtained by cutting out the arbitrary region of 3.0 mm × 2.2 mm in the PL image, the [11-20] direction was processed using image processing software (product name: WinROOF2015) with a Prewitt filter using a kernel of 5 × 5. The result is shown in Figure 6. At an arbitrary position in the image after the filter processing, a 500 µm line segment (in Figure 6, a part shown by a lower-left line segment) parallel to the [11-20] direction was drawn. A graph was created by plotting PL intensity I_{F} as the vertical axis versus distance (µm) in the [11-20] direction as the horizontal axis in the line segment region. The graph is shown in Figure 7. This graph had a shape such that a plurality of maximum points is repeated. The maximum point was confirmed to be a point that gives PL intensity I_{F} higher than PL intensity I_{F} of any other point among six points in total consisting of points that are the first nearest, points that are the second nearest, and points that are the third nearest on the right and left of the maximum point. In addition, distance L_{F} in the [11-20] direction between a given maximum point P_{M}, and a maximum point P_{M2} whose distance in the horizontal direction is longer than that of the maximum point P_{M1}, and the maximum point P_{M2} being present at a position nearest to the maximum point P_{M1}, was measured from this image. The result was as shown in Table 1.

### (5-3) Boron Concentration in Biaxially Oriented SiC Layer

The sample obtained by processing the heat-treated layer (biaxially oriented SiC layer) produced in (1) to (4) into a chip shape was used as an evaluation sample to quantitatively determine the boron concentration inside the biaxially oriented SiC layer by secondary ion mass spectrometry (SIMS). The boron concentration from the (0001) plane that is a substrate surface of the evaluation sample to a depth of 10 µm was measured to find that the boron concentration was almost constant irrespective of the depth of the biaxially oriented SiC layer and the boron concentration was as shown in Table 1. Even though a boron compound was not added in the present example, boron was detected in the biaxially oriented SiC layer, but this merely shows that boron as an inevitable impurity was detected. The analysis conditions at this time were as shown below.

### <Conditions for SIMS Analysis>

- Primary ion species: O₂⁺
- Primary acceleration voltage: 11.0 kV
- Detection region: Diameter 30 µm
- Detection depth: 10 µm

### (5-4) Threading Screw Dislocation (TSD) Density of Heat-Treated Layer (Biaxially Oriented SiC Layer)

The sample obtained by processing the SiC composite substrate obtained in (1) to (3-1) into a chip shape by (4) was used as an evaluation sample to measure the TSD density (cm⁻²) of the biaxially oriented SiC layer. The evaluation sample was placed together with a KOH crystal in a crucible made of nickel and was subjected to etching treatment in an electric furnace at 500°C for 10 minutes. The evaluation sample after the etching treatment was rinsed, and the surface thereof was observed with an optical microscope to determine the kind of dislocation from the shapes of pits. Here, a shell-like shape pit was regarded as a basal plane dislocation, a small hexagonal pit was regarded as a threading edge dislocation, and a middle to large hexagonal pit was regarded as the TSD to measure the TSD density. Subsequently, the surface of this evaluation sample was polished by the same procedure as in (3-1), and the etching treatment and the measurement of the TSD density were repeated a plurality of times in the same manner as described above to obtain the TSD density at a plurality of depths. Thus, a graph was obtained by plotting the TSD density (cm⁻²) as the vertical axis versus depth (polished thickness) (µm) from the (0001) plane that is a substrate surface of the evaluation sample to an arbitrary (000-1) plane as the horizontal axis, as shown in Figure 8. In Figure 8, a region (a region from a polished thickness of about 380 to about 400 µm) where the TSD density increases in the (0001) plane to the (000-1) plane, that is, a region where the TSD density decreases at a constant slope a as the depth decreases in the (0001) plane to the arbitrary (000-1) plane, was defined as a TSD sloped region. In this graph in the TSD sloped region, an approximation straight line was determined by the least-squares method to determine the absolute value of the slope a of the TSD density against the polished thickness. Further, the TSD density of the (0001) plane of the evaluation sample at a polished thickness of 50 µm was regarded as the TSD density of the SiC substrate surface and measured. The results were as shown in Table 1.

### Example 2 (Comparison)

A SiC substrate was produced and evaluated as in Example 1 except that the annealing temperature was set to 2200°C in (2). The heat-treated layer of the resultant SiC substrate was confirmed to be a biaxially oriented SiC layer. The results were as shown in Table 1.

### Example 3

A SiC substrate was produced and evaluated as in Example 1 except that a powder containing 85.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 5.0% by weight of a boron carbide powder (volume-based D50 particle size: 0.5 µm) was used as the raw material powder in (1). The heat-treated layer of the resultant SiC substrate was confirmed to be a biaxially oriented SiC layer. The results were as shown in Table 1.

### Example 4

A SiC substrate was produced and evaluated as in Example 1 except that a powder containing 80.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 10.0% by weight of a boron carbide powder (volume-based D50 particle size: 0.5 µm) was used as the raw material powder in (1). The heat-treated layer of the resultant SiC substrate was confirmed to be a biaxially oriented SiC layer. The results were as shown in Table 1.

### Example 5

A SiC substrate was produced and evaluated as in Example 1 except that a powder containing 70.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 20.0% by weight of a boron carbide powder (volume-based D50 particle size: 0.5 µm) was used as the raw material powder in (1). The heat-treated layer of the resultant SiC substrate was confirmed to be a biaxially oriented SiC layer. The results were as shown in Table 1.

### Example 6 (Comparison)

A SiC substrate was produced and evaluated as in Example 1 except that a powder containing 60.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 30.0% by weight of a boron carbide powder (volume-based D50 particle size: 0.5 µm) was used as the raw material powder in (1). The heat-treated layer of the resultant SiC substrate was confirmed to be a biaxially oriented SiC layer. The results were as shown in Table 1.

### Example 7

A SiC substrate was produced and evaluated as in Example 1 except that the annealing temperature was set to 2350°C in (2). The heat-treated layer of the resultant SiC substrate was confirmed to be a biaxially oriented SiC layer. The results were as shown in Table 1.

### [Table 1]

**Table 1**

| | T (°C) | C_{BT} (% by weight) | C_{B} (×10¹⁶atoms/cm³) | M/m | L (µm) | L_{F} (µm) | Absolute value of a (cm⁻²/µm) | D_{TSD} (cm⁻²) |
|---|---|---|---|---|---|---|---|---|
| Ex. 1 | 2400 | 0 | 1.1 | 1.56 | 70.2 | 144 | 14 | 20 |
| Ex. 2* | 2200 | 0 | 1.0 | 1.03 | 42.1 | 86.1 | 0.041 | 290 |
| Ex. 3 | 2400 | 5 | 3.3 | 1.12 | 85.7 | 152 | 7.1 | 30 |
| Ex. 4 | 2400 | 10 | 5.1 | 1.58 | 114 | 224 | 16 | 10 |
| Ex. 5 | 2400 | 20 | 9.3 | 1.45 | 144 | 293 | 20 | 20 |
| Ex. 6* | 2400 | 30 | 13 | 1.39 | 180 | 349 | 0.082 | 320 |
| Ex. 7 | 2350 | 0 | 1.1 | 1.22 | 19.1 | 35.4 | 15 | 10 |

| | | | | | | | | |
|---|---|---|---|---|---|---|---|---|
| T: the heat treatment temperature C_{BT}: the content of the boron compound in the raw material powder C_{B}: the boron concentration in the biaxially oriented SiC layer M/m: the ratio of the maximum value M to the minimum value m L: the distance in the [11-20] direction between the maximum point P_{M} and the mini mum point Pₘ L_{F}: the distance between maximum points in PL intensity in the graph after Prewitt f ilter processing a: the slope of TSD density with respect to polished thickness D_{TSD}: the TSD density of the (0001) plane at a polished thickness of 50 µm * indicates a comparative example. | | | | | | | | |

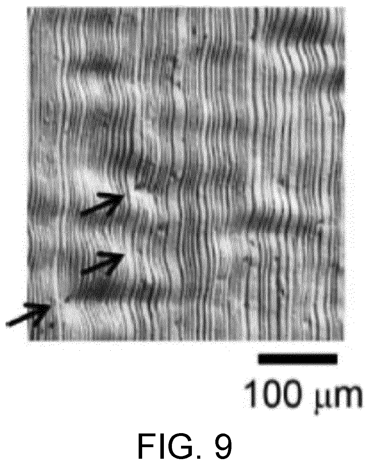

It was found from Examples 1 to 7 that the distribution of PL intensity versus the distance in the [11-20] direction can be controlled by the annealing temperature and the boron content, although the cause is not certain. In addition, as shown in Examples 1, 3 to 5, and 7, it was found that when the ratio of M/m is 1.05 or more and the distance L is 15 to 150 µm in the graph obtained by PL, or when the distance L_{F} is 30 to 300 µm in the graph obtained by processing, with a Prewitt filter, the image obtained by PL, thereby the TSD density of the (0001) plane of the evaluation sample at a polished thickness of 50 µm, that is, the TSD density of the surface of the biaxially oriented SiC layer can be decreased. Further, it was found that in the SiC substrate including a biaxially oriented SiC layer and being such that in the graph obtained by plotting the TSD density as the vertical axis versus the depth from the (0001) plane that is the substrate surface to an arbitrary (000-1) plane as the horizontal axis, a TSD sloped region where the TSD density decreases at a constant slope a as the depth decreases and the absolute value of the slope a is 5.0 cm⁻²/µm or more is present, the TSD density of the surface of the biaxially oriented SiC layer can be effectively decreased. It is considered that this is because the distribution of PL intensity versus the distance in the [11-20] direction reflects a step-terrace structure generated during crystal growth, and the TSDs were converted to lamination defects with the crystal growth. On the other hand, as was the case in Examples 2 and 6, when the firing temperature was low and the ratio of M/m fell below 1.05, when the distance L exceeded 150 µm, or when the distance L_{F} exceeded 300 µm, the absolute value of the slope a of the TSD density remarkably decreased, and the TSD density of the surface of the biaxially oriented SiC layer increased. It is considered that this is because the step-terrace structure collapsed, and therefore the TSDs were not converted to lamination defects. In this respect, as shown in Figure 4, it was found that in the step-terrace structure at the surface of the biaxially oriented SiC layer of the SiC substrate, which shows an example of the present invention, the step width is wide, as wide as about 100 to about 200 µm. On the other hand, according to Non-Patent Literature 2 (Toru Ujihara et al. "Conversion Mechanism of Threading Screw Dislocation during SiC Solution Growth" Materials Science Forum Vols. 717-720, pp. 351-354 (2012)), the step width on the surface of a SiC substrate produced by a solution growth method is very narrow, as narrow as 20 µm or less, as shown in Figure 9. Such a difference in the step-terrace structure is considered to give an influence on the TSD density of the SiC substrate surface.

## Claims

1. A SiC substrate comprising a biaxially oriented SiC layer, wherein when a surface of the biaxially oriented SiC layer is analyzed by photoluminescence (PL) to obtain a graph by plotting PL intensity I as the vertical axis versus distance (µm) in the [11-20] direction as the horizontal axis,
(i) the graph has a shape such that a maximum point and a minimum point are repeated, wherein the maximum point is defined as a point that gives PL intensity I higher than PL intensity I of any other point among six points in total consisting of points that are the first nearest, points that are the second nearest, and points that are the third nearest on the right and left of the maximum point, and the minimum point is defined as a point that gives PL intensity I lower than PL intensity I of any other point among six points in total consisting of points that are the first nearest, points that are the second nearest, and points that are the third nearest on the right and left of the minimum point,
(ii) when a maximum value of PL intensity I at a given maximum point P_{M} is assumed to be M, and a minimum value of PL intensity I at a minimum point Pₘ whose distance in the horizontal axis direction is longer than that of the maximum point P_{M}, and the minimum point Pₘ being present at a position nearest to the maximum point P_{M}, is assumed to be m, a ratio of M/m is 1.05 or more, and
(iii) distance L in the [11-20] direction between the maximum point P_{M} and the minimum point Pₘ is 15 to 150 µm.

2. The SiC substrate according to claim 1, wherein the distance L is 50 to 150 µm.

3. A SiC substrate comprising a biaxially oriented SiC layer, wherein when in an image obtained by analyzing a surface of the biaxially oriented SiC layer by photoluminescence (PL), the [11-20] direction of the image is processed with a Prewitt filter to obtain a graph by plotting PL intensity I_{F} as the vertical axis versus distance (µm) in the [11-20] direction as the horizontal axis,
(i) the graph has a shape such that a plurality of maximum points is repeated, wherein the maximum point is defined as a point that gives PL intensity I_{F} higher than PL intensity I_{F} of any other point among six points in total consisting of points that are the first nearest, points that are the second nearest, and points that are the third nearest on the right and left of the maximum point, and
(ii) distance L_{F} in the [11-20] direction between a given maximum point P_{M}, and a maximum point P_{M2} whose distance in the horizontal axis direction is longer than that of the maximum point P_{M1}, the maximum point P_{M2} being present at a position nearest to the maximum point P_{M1}, is 30 to 300 µm.

4. The SiC substrate according to claim 1 or 3, wherein the biaxially oriented SiC layer is oriented in the c-axis direction and the a-axis direction, and when a graph is obtained for the biaxially oriented SiC layer by plotting threading screw dislocation (TSD) density (cm⁻²) as the vertical axis versus depth (µm) from a (0001) plane that is a substrate surface to an arbitrary (000-1) plane as the horizontal axis, the graph comprises a TSD sloped region where the TSD density is decreased at a constant slope a as the depth decreases and the absolute value of the slope a is 5.0 cm⁻²/ µm or more.

5. The SiC substrate according to claim 1 or 3, wherein the biaxially oriented SiC layer comprises boron in a concentration of 1.0 × 10¹⁶ to 1.0 × 10¹⁷ atoms/cm³.

6. The SiC substrate according to claim 4, wherein the absolute value of the slope a is 5.0 to 25 cm⁻²/ µm.

7. A SiC composite substrate comprising:
a SiC single crystal substrate; and
the SiC substrate according to claim 1 or 3 on the SiC single crystal substrate.
